# EUROPEAN PATENT APPLICATION

(11) **EP 2 426 711 A2**
(43) Date of publication of application: **07.03.2012**
(21) Application number: 10769900.1
(22) Date of filing: 23.04.2010
(51) Int. Cl.: H01L 23/34, H05K 7/20, G06F 1/20

(54) **HEAT SINK FOR A PROTRUSION-TYPE IC PACKAGE**

(30) Priority: 28.04.2009 KR 20090005143 U
(71) Applicant: HNS Solution Co., Ltd., Gyeonggi-do, 464-909 (KR)
(72) Inventor: SHIN, Hyun Bo, Seoul 135-280 (KR); NAM, Dong Jin, Yongin-si Gyeonggi-do 446-565 (KR)
(74) Representative: Grosse, Felix Christopher
(86) International application number: PCT/KR2010/002545
(87) International publication number: WO 2010/126255

(57) **Abstract**

The present invention relates to a heat dissipation plate for a projection-type integration circuit (IC) package, which is installed to be adhered and fixed to a projection-type IC package in which an integration circuit in a board is formed to project, so as to dissipate heat generated by the integrated circuit, including: a fixed plate adhered and fixed to the projection-type IC package; and heat dissipation fins (cooling fins) formed to be inclined upward from both opposing sides of the fixed plate, wherein an accommodation groove that accommodates the integrated circuit is formed in a rear surface of the fixed plate, and the accommodation groove is formed to have a shape to be joined to the integrated circuit, and the integrated circuit comes into close contact with the accommodation groove. Therefore, there are advantages in that the heat dissipation plate can enhance not only heat dissipation efficiency but also adhesion performance by increasing the contact area with the projection-type IC package, and simultaneously can be simply produced, thereby reducing production costs.

## Description

### [Technical Field]

This disclosure relates to a heat dissipation plate for a projection-type IC package in which an integrated circuit (IC) in a board is formed to project, and more particularly, to a heat dissipation plate for a projection-type IC package which is installed to be joined and fixed to a projection-type IC package and effectively dissipates heat generated by an integrated circuit.

### [Background Art]

An integrated circuit (IC) package that is introduced in order to solve a technical demand according to a tendency toward an increase in the number of pins has solder balls fused to a surface of the IC package or uses a number of lead wires provided in a side surface of the IC package as input and output means, and thus accommodates a large number of input and output signals and is formed with a small size.

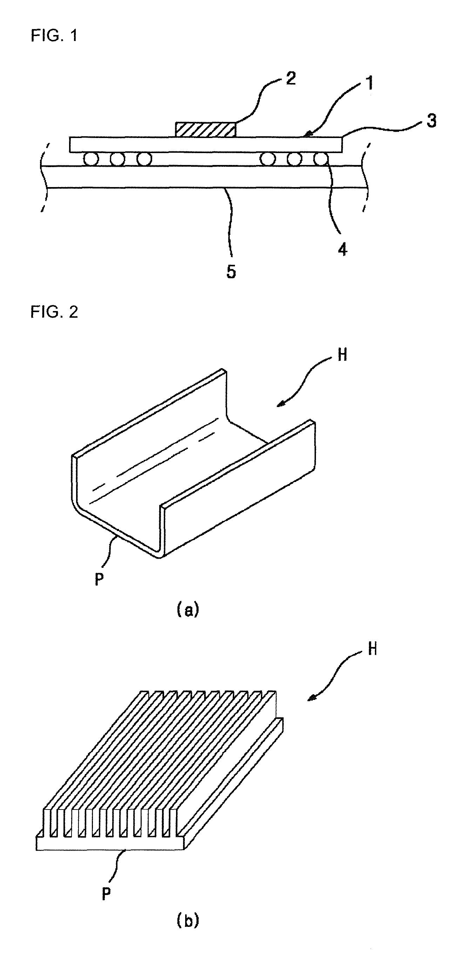

A projection-type IC package 1 from among various types of IC packages is shown in Fig. 1. The structure of the projection-type IC package 1 is characterized in that an integrated circuit 2 is mounted on the surface of a board 3, the integrated circuit 2 and the board 3 are connected to form an electrical connection, and particularly, the integrated circuit 2 is formed to project from the board 3. The projection-type IC package 1 includes various kinds of input and output means according to the type, and for example, includes solder balls 4 fused on the rear surface in an array form or a number of lead wires (not shown) on the side surface.

The projection-type IC package 1 is mounted on a printed circuit board 5 to be operated.

The projection-type IC package 1 generates much heat during operations of the integrated circuit, and when the generated heat cannot be effectively dissipated to the outside, the performance of a semiconductor package is degraded.

Therefore, in order to maximize the heat dissipation effect of the above-described projection-type IC package, there is a need to install a heat dissipation plate on the IC package to dissipate heat generated by the integrated circuit to the outside.

However, as a heat dissipation plate according to the related art used in a projection-type IC package, a typical heat dissipation plate H as shown in Figs. 2(a) and 2(b) is used as it is, so that heat dissipation of the projection-type IC package cannot be effectively performed. That is, in a case where the heat dissipation plate H according to the related art as in Figs. 2(a) and 2(b) is installed on the projection-type IC package, since the integrated circuit mounted on the projection-type IC package is formed to project from the board while the rear surface of a fixed plate P of the heat dissipation plate is formed as a flat surface, the contact area is limited only to the top of the integrated circuit, so that there are problems in that heat dissipation performance is not high and adhesion performance of the heat dissipation plate is degraded.

### [Disclosure]

### [Technical Problem]

An object of the present invention is to provide, as a heat dissipation plate used for a projection-type IC package in which an integrated circuit (IC) in a board is formed to project, a heat dissipation plate for a projection-type IC package which can enhance not only heat dissipation efficiency but also adhesion performance by increasing the contact area with the projection-type IC package, and simultaneously can be simply produced, thereby reducing production costs.

### [Technical Solution]

In order to accomplish the object, the present invention provides a heat dissipation plate for a projection-type integration circuit (IC) package, which is installed to be adhered and fixed to a projection-type IC package in which an integration circuit in a board is formed to project, so as to dissipate heat generated by the integrated circuit, including: a fixed plate adhered and fixed to the projection-type IC package; and heat dissipation fins (cooling fins) formed to be inclined upward from both opposing sides of the fixed plate, wherein an accommodation groove that accommodates the integrated circuit is formed in a rear surface of the fixed plate, and the accommodation groove is formed to have a shape to be joined to the integrated circuit, and the integrated circuit comes into close contact with the accommodation groove.

The accommodation groove may be formed by a press process.

A surface of the fixed plate may be provided with a projection portion formed to project from the surface, the projection portion may include a projection surface and a projection connection surface formed along a periphery of the projection surface, and the projection connection surface may be formed to be inclined with respect to the projection surface and the surface of the fixed plate.

An angle between the fixed plate and the heat dissipation plate is preferably greater than 90 degrees and equal to or smaller than 150 degrees.

The heat dissipation fin may be provided with a plurality of though-holes.

### [Advantageous Effects]

According to the present invention, when the heat dissipation plate is adhered and fixed to the projection-type integration circuit (IC) package in which the integrated circuit in the substrate is formed to project, the contact area is increased, and thus not only the heat dissipation efficiency but also the adhesion performance can be enhanced. In addition, the heat dissipation plate according to the present invention can be easily produced by a press process or extrusion molding, so that the heat dissipation plate can be more efficiently produced without high production costs.

### [Description of Drawings]

The above and other aspects, features and advantages of the disclosed exemplary embodiments will be more apparent from the following detailed description taken in conjunction with the accompanying drawings in which:
Fig. 1 is a diagram showing the configuration of a projection-type IC package.
FIG. 2 is a diagram showing a heat dissipation plate according to related art.
Fig. 3(a) is a perspective view of a heat dissipation plate for a projection-type IC package according to an embodiment of the present invention, Fig. 3(b) is a cross-sectional view taken along the line A-A of Fig. 3(a), and Fig. 3(c) is a cross-sectional view of a heat dissipation plate for a projection-type IC package according to the present invention, which is joined and fixed to the projection-type IC package.
Fig. 4 is a perspective view of a heat dissipation plate for a projection-type IC package according to another embodiment of the present invention.

### [Best Mode]

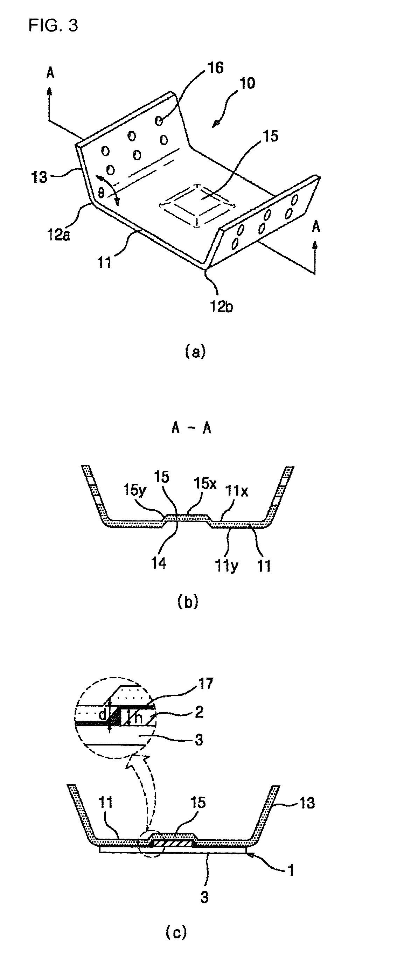

Fig. 3(a) is a perspective view of a heat dissipation plate 10 for a projection-type IC package according to a preferable embodiment of the present invention, Fig. 3(b) is a cross-sectional view taken along the line A-A of Fig. 3(a), and Fig. 3(c) is a side cross-sectional view of the heat dissipation plate for a projection-type IC package which is joined and fixed to a projection-type IC package 1.

The heat dissipation plate 10 for a projection-type integrated circuit (IC) package according to the present invention is installed to be joined and fixed to the projection-type IC package 1 in which an integrated circuit 2 is formed to project, so as to dissipate heat generated by the integrated circuit 2.

The heat dissipation plate 10 for a projection-type IC package is characterized in that it includes a fixed plate 11 joined and fixed to the projection-type IC package 1, and heat dissipation fins (cooling fins) which are formed to be inclined upward from both opposing sides of the fixed plate, wherein an accommodation groove which accommodates the integrated circuit is formed on the rear surface of the fixed plate, the accommodation groove is formed into a shape to be joined to the integrated circuit, and the integrated circuit comes into close contact with the accommodation groove.

### [Mode for Invention]

Hereinafter, the preferable embodiment will be described in more detail with reference to the accompanying drawings. However, it should be clearly understood by those skilled in the art that the embodiments are for describing the present invention more specifically and the scope of the present invention is not limited by the embodiments.

The heat dissipation plate 10 for a projection-type IC package may be produced of any one selected from the groups consisting of aluminum, copper, zinc, silver, gold, iron, and an alloy of the metals.

An accommodation groove 14 which accommodates the integrated circuit 2 is formed on a rear surface 11 y of the fixed plate 11 joined to the projection-type IC package 1. As the integrated circuit 2 of the projection-type IC package is accommodated in the accommodation groove 14, the contact area of the projection-type IC package 1 and the heat dissipation plate 10 is increased, thereby enhancing heat dissipation performance and adhesion performance. With regard to the heat dissipation plate 10 used in an apparatus which requires a slim thickness such as a mobile device, the heat dissipation plate 10 may be configured by accommodating the integrated circuit 2 in the accommodation groove 14 formed in the fixed plate 11 while a heat dissipation fin 13 is not provided. If an apparatus to which the heat dissipation plate is attached ensures a sufficient internal space, the heat dissipation performance may further be enhanced by forming the heat dissipation fin 13.

The accommodation groove 14 of the fixed plate 11 may be easily formed by subjecting the fixed plate 11 to a forming process using a press die with a shape corresponding to the integrated circuit. Therefore, the accommodation groove 14 is formed into a shape to be joined to the integrated circuit 2, so that the heat dissipation plate 10 may be closely fixed to the projection-type IC package.

A surface 11x of the fixed plate 11 is provided with a projection portion 15 formed to project from the surface 11x. The projection portion 15 includes a projection surface 15x and a projection connection surface 15y formed along the periphery of the projection surface 15x. The projection connection surface 15y is inclined with respect to the surface 11x of the fixed plate 11 and the projection surface 15x of the projection portion 15 as shown in Fig. 3(b).

The heat dissipation plate 10 having the projection portion 15 on the surface has a widened contact area with the air due to the projection connection surface 15y, so that the heat dissipation performance may further be enhanced.

The above-described projection portion 15 may be formed as the surface 11x projects in a case where the accommodation groove 14 is formed by subjecting the rear surface 11 y of the heat dissipation plate 10 having a sheet shape to a press process.

Meanwhile, since the heat dissipation plate 10 and the projection-type IC package 1 may be joined and fixed to each other by an adhesive 17 as described later, a depth d of the accommodation groove is preferably greater than a projection height h of the integrated circuit.

The fixed plate 11 of the heat dissipation plate 10 and the projection-type IC package 1 may be joined to each other though the adhesive 17 such as thermal conductive silicone sheet, a thermal conductive acrylic adhesive, or a thermal conductive acrylic form tape. The adhesive not only adheres the heat dissipation plate to the projection-type IC package but also increases thermal conductivity, thereby having a function of enhancing the heat dissipation performance of the projection-type IC package.

As shown in Fig. 3(c), when the heat dissipation plate 10 for a projection-type IC package according to the preferable embodiment of the present invention is adhered and fixed onto the projection-type IC package 1, the contact area of the fixed plate 11 and the projection-type IC package 1 is not limited only to the integrated circuit as in the heat dissipation plate according to the related art but extends to a printed circuit board 3 of the projection-type IC package, so that heat dissipation area is large and the adhesion performance may also be enhanced. That is, the heat dissipation plate according to the present invention has an advance in further increasing the heat dissipation efficiency while being firmly fixed onto the projection-type IC package.

In addition, the heat dissipation fin 13 may be provided with a plurality of though-holes 16 as shown in Fig. 3(a). The through-holes 16 increase the contact area with the air and thus enhance the performance of the heat dissipation fin.

The heat dissipation fins 13 are formed to be inclined upward from both opposing sides 12a and 12b of the fixed plate 11 and the angle θ between the fixed plate 11 and the heat dissipation fin 13 is preferably 90 to 150 degrees. If the angle between the fixed plate and the heat dissipation fin is an acute angle, the fixed plate and the heat dissipation fin are too close to each other to generate convection of the air. If the angle exceeds 150 degrees, a convection space is not ensured and thus heat dissipation is less likely to occur.

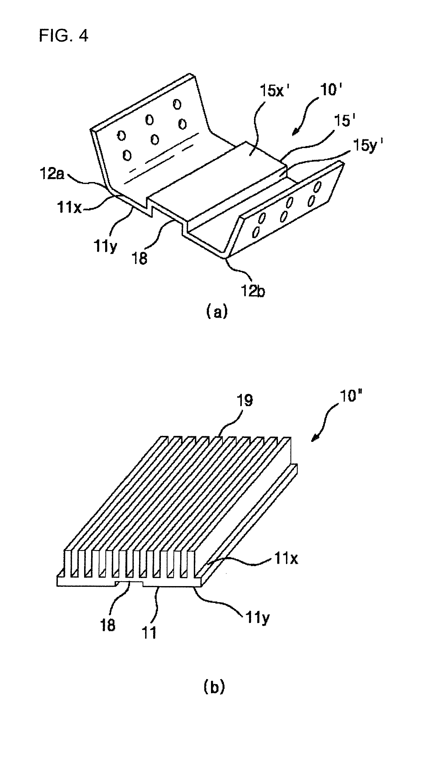

Fig. 4(a) is a schematic perspective view of a heat dissipation plate 10' for a projection-type IC package according to another preferable embodiment of the present invention, and Fig. 4(b) is a schematic perspective view of a heat dissipation plate 10" for a projection-type IC package according to still another preferable embodiment of the present invention, and

The heat dissipation plate for a projection-type IC package shown in Fig. 4(a) has a structure similar to that of the heat dissipation plate shown in Fig. 3 except that an insertion groove 18 is formed in the rear surface 11y of the fixed plate 11 instead of the accommodation groove.

In order to increase the adhesion with the projection-type IC package, the fixed plate 11 of the heat dissipation plate 10' is provided with the insertion groove 18 in parallel with both opposing sides 12a and 12b. The insertion groove 18 corresponding to the width of the integrated circuit is a configuration for increasing the contact area between the projection-type IC package and the heat dissipation plate and the adhesion performance and simultaneously for facilitating production. The insertion groove 18 and the projection-type IC package are joined and fixed to each other by the adhesive and thus the depth of the insertion groove is preferably greater than the projecting height of the integrated circuit.

In addition, the surface 11x of the fixed plate 11 is provided with a projection portion 15' at a position corresponding to the insertion groove 18. The projection portion 15' includes a projection surface 15x' and a projection side surface 15y' that connects the projection surface to the surface of the fixed plate. The heat dissipation plate 10' increases the contact area with the air due to the projection side surface, so that the heat dissipation performance of the heat dissipation plate may further be enhanced.

The heat dissipation plate for a projection-type IC package shown in Fig. 4(a) may be produced by extrusion molding using a die of which a side end surface is opened, so that there is an advantage in that production may be simply performed and production costs may be reduced.

In addition, when the heat dissipation plate is installed on the projection-type IC package, a space separated from the projection-type IC package is formed along the lengthwise direction of the insertion groove 18, and heat transfer may be achieved in the space by natural convection of the air, so that the heat dissipation performance may be not much degraded.

The heat dissipation plate 10" for a projection-type IC package shown in Fig. 4(b) includes a plurality of heat dissipation fins 19 on the surface 11x of the fixed plate 11 and the insertion groove 18 on the rear surface 11y of the fixed plate 11. Since the insertion groove 18 is formed along the lengthwise direction of the heat dissipation fin 19, the heat dissipation plate 10" according to this embodiment may also be easily produced using a die for extrusion molding.

In addition, although not shown in the figures, by forming an accommodation groove (not shown) in which the integration circuit of the projection-type IC package may be accommodated in the rear surface 11y of the fixed plate 11 instead of the insertion groove 18, the contact area and the adhesion performance may be enhanced. Of course, the accommodation groove may be formed by a press process as described above.

Those skilled in the art will appreciate that the conceptions and specific embodiments disclosed in the foregoing description may be readily utilized as a basis for modifying or designing other embodiments for carrying out the same purposes of the present invention. Those skilled in the art will also appreciate that such equivalent embodiments do not depart from the spirit and scope of the present invention as set forth in the appended claims.

## Claims

1. A heat dissipation plate for a projection-type integration circuit (IC) package, which is installed to be adhered and fixed to a projection-type IC package in which an integration circuit in a board is formed to project, so as to dissipate heat generated by the integrated circuit, comprising:
a fixed plate adhered and fixed to the projection-type IC package; and
heat dissipation fins (cooling fins) formed to be inclined upward from both opposing sides of the fixed plate,
wherein an accommodation groove that accommodates the integrated circuit is formed in a rear surface of the fixed plate, and
the accommodation groove is formed to have a shape to be joined to the integrated circuit, and the integrated circuit comes into close contact with the accommodation groove.

2. The heat dissipation plate according to claim 1, wherein the accommodation groove is formed by a press process.

3. The heat dissipation plate according to claim 1,
wherein a surface of the fixed plate is provided with a projection portion formed to project from the surface,
the projection portion includes a projection surface, and a projection connection surface formed along a periphery of the projection surface, and
the projection connection surface is formed to be inclined with respect to the projection surface and the surface of the fixed plate.

4. The heat dissipation plate according to claim 1, wherein an angle between the fixed plate and the heat dissipation plate is greater than 90 degrees and is equal to or smaller than 150 degrees.

5. The heat dissipation plate according to claim 1, wherein the heat dissipation fin is provided with a plurality of though-holes.
